Europäisches Patentamt

European Patent Office

Office européen des brevets

(19)

(11) Publication number: **0 024 872**
**B2**

(12) **NEW EUROPEAN PATENT SPECIFICATION**

(45) Date of publication of the new patent specification: **07.12.88**

(51) Int. Cl.⁴: **G 03 F 7/08, B 41 N 3/08**

(21) Application number: **80302863.8**

(22) Date of filing: **19.08.80**

(54) **A method of treating exposed and developed radiation sensitive plates in lithographic printing plate production, compositions for use in the method, and the use of diazo eliminating compounds in improving the ink receptivity of lithographic printing images.**

(30) Priority: **20.08.79 GB 7928902**

(43) Date of publication of application:
**11.03.81 Bulletin 81/10**

(45) Publication of the grant of the patent:
**14.03.84 Bulletin 84/11**

(45) Mention of the opposition decision:
**07.12.88 Bulletin 88/49**

(84) Designated Contracting States:
**AT BE CH DE FR GB IT LI LU NL SE**

(73) Proprietor: **Vickers Limited**
**P.O. Box 177 Vickers House Millbank Tower**
**London SW1P 4HA (GB)**

(72) Inventor: **Gates, Allen Peter**
**13 Fountains Way**
**Knaresborough Yorkshire (GB)**
Inventor: **Dawson, Elizabeth Anne**
**15 Rutland Drive Kippax**
**Leeds 25 Yorkshire (GB)**

(74) Representative: **Overbury, Richard Douglas et al**
**HASELTINE LAKE & CO Hazlitt House 28**
**Southampton Buildings Chancery Lane**
**London WC2A 1AT (GB)**

(56) References cited:
WO-A-79/00593
DE-A-2 615 075
DE-A-2 626 473
DE-A-2 636 119
DE-A-2 637 768
DE-C- 857 739
FR-A-1 419 726
FR-A-1 602 009
FR-A-2 020 081
FR-A-2 306 832
FR-A-2 316 636
FR-A-2 366 598

(56) References cited:
US-A-3 373 021
US-A-3 669 660

Hans Beyer "Lehrbuch der Organischen Chemie" S. Hirzel Verlag Leipzig, 5. Auflage 1958, Seite 345

Courier Press, Leamington Spa, England.

**Description**

This invention relates to lithographic printing.

As is well known, a lithographic printing plate consists of ink receptive image areas and water receptive non-image areas lying in substantially the same plane. Nowadays, virtually all lithographic plates are formed from radiation sensitive plates comprising a radiation sensitive coating on a suitable substrate. Image-wise exposure of such a radiation sensitive plate to radiation using a suitable transparency causes the coating to change its characteristics in the areas struck by the radiation. In the most common form of plate i.e. a subtractive plate, the change in characteristics allows the coating to be selectively removed from the substrate in the non-image areas by the application of a suitable developer to leave an image on the substrate. In the case of the so-called positive working plate, the radiation struck areas of the coating are removed whereas in the case of the so-called negative working plates it is the non-radiation struck areas of the coating which are removed.

for health and environmental reasons, the trend in nagative working plates has been away from using coatings which need an organic solvent developer to remove the non-radiation struck areas and towards those coatings where the non-radiation struck areas can be removed with a substantially aqueous developer.

Coatings containing diazo compound as the main radiation sensitive constituent are well known for use in aqueous developable plates and, in particular, those based on the condensation products of diazodiphenylamine and a compound containing a reactive carbonyl group such as formaldehyde. Coatings containing such condensation products are well documented in the patent literature. In this regard reference may be made to British Patent Specifications No. 950,761, No. 1,019,919, No. 1,023,589, No. 1,055,079, No. 1,302,717, No, 1,388,038, and, in particular No. 1,312,925.

However radiation sensitive plates based on such coatings have not been entirely satisfactory in that the image is frequently reluctant to accept ink.

In the use of such radiation sensitive plates to produce lithographic printing plates, the coating is exposed to radiation to an extent such that sufficient diazo groups are destroyed to produce an insolubilised product in the radiation struck areas. Bowever it has been found that, under the conditions used in practice this photolysis process is incomplete and that the radiation struck areas contain residual diazo groups. It has also been found that, during further processing of the plate, these residual diazo groups can enter into reactions which are detrimental to the performance of the plate. More particularly it has been found that the residual diazo groups in the radiation struck areas (which are the image areas) can react with materials such as gum arabic, dextrin, etc. used in the final stage of the processing to desensitise and protect the non-image areas. Such desensitising materials are hydrophilic and their reaction with the diazo groups causes hydrophilic material to be incorporated or bound into the image areas making the latter reluctant to accept ink. Such a reaction can take place merely by leaving a plate that has been treated with such materials in the dark at ambient temperature. The reaction will take place much quicker at elevated temperatures or if the plate is exposed to light.

It is an object of the present invention to overcome the foregoing problem.

According to one aspect of the present invention, there is provided a method producing a lithographic printing plate from a radiation sensitive plate comprising a substrate having thereon a radiation sensitive coating containing a diazo compound, the method comprising image-wise exposing the radiation sensitive plate, developing the image-wise exposed plate to selectively remove the non-radiation struck areas of the coating from the substrate and applying a lithographic desensitising material to the developed plate characterised in that the developed plate is treated with a finishing composition either prior to, or simultaneously with, the application of the lithographic desensitising material said finishing composition comprising an active methylene group-containing compound capable of eliminating diazo groups by entering into an azo coupling reaction.

It has been found that the elimination of the diazo groups takes place in preference to the aforementioned reaction between the diazo groups and the desensitising material. Thus, the two steps of eliminating the residual diazo groups and of desensitising the plate can be carried out simultaneously using a single composition.

Accordingly, a further aspect of the present invention provides a plate finishing composition suitable for use in the above defined method which composition comprises (i) an active methylene group-containing compound capable of eliminating diazo groups by entering into an azo coupling reaction, (ii) a lithographic desensitising material, and (iii) water.

Said active methylene group-containing compound may be, for example, acetoacetanilide; 3 - hydroxy - acetoacetanilide; 4 - chloro-2,5 - dimethoxyacetanilide; 4 - morpholinoacetoanilide; N - acetoacetylbenzylamine; N,N' - bis-acetoacetylethylene diamine; 1 - phenyl - 3 - methyl - 5 - pyrazolone; or N - (cyanoacetyl)-morpholine.

The lithographic desensitising material is preferably dextrin or gum arabic. Examples of other suitable lithographic desensitising materials are alginates (such as sodium, potassium or ammonium alginate); cellulose derivatives (such as methyl cellulose, hydroxy propyl cellulose, hydroxyethyl cellulose or carboxy methyl cellulose); acrylamide homopolymer; and polymers containing structural units derived from acrylamide and from 1 to 25% by weight of structural units containing carboxyl groups.

The finishing compositions are generally aqueous solutions and contain sufficient amounts of said diazo eliminating compound and said sesensitising material to substantially completely destroy the residual diazo groups and to adequately desensitise the non-image areas, respectively. Generally the composition will contain from about 0.5 to about 50% by weight of aid desensitizing material and the content of said compound cabable of eliminating diazo groups will be from about 0.25% by weight up to the amount required to form a saturated solution. The latter amount will depend upon the nature of the compound capable of eliminating diazo groups and on the presence of other components in the composition. Such other components may be, for example, a surfactant and/or a dispersing agent to assist in dissolution of the diazo group eliminating compound and desensitising material and/or acid or alkali to provide pH suitable for the particular diazo group eliminating compound and desensitising material used. In this regard, the finishing composition will generally be alkaline. Examples of such other components are the sodium salt of dodecylated oxydibenzene disulphonic acid, sodium polyacrylate, hydrochloric acid, potassium hydrogen phosphate, disodium hydrogen phosphate, trisodium phosphate and sodium hydroxide.

The compositions of the present invention are normally produced by stirring together the water, the diazo eliminating compound, the lithographic desensitising material and any other components as appropriate under ambient conditions. If desired, however, the mixing may be effected at slightly elevated temperature in order to assist dissolution. Thus, by way of examples, the trisodium phosphate or other pH-adjusting component may be added to the water heated to about 60°C followed by the addition of the sodium salt of dodecylated oxydibenzene disulphonic acid or other surfactant and then by the addition of the acetoacetanilide or other diazo eliminating compound. Thereafter the dextrin or other lithographic desensitising material is added to obtain the desired composition.

By means of the present invention it is possible to increase the ink receptively of the printing images of lithographic plates formed from radiation sensitive coatings based on diazo compounds.

The following Examples, in which percentages are by weight, illustrate the invention:—

### Example 1

Eight sheets of grained, anodised and silicated aluminium were coated with the following radiation sensitive compositions and dried to form eight radiation sensitive plates:

Plate 1:
An aqueous solution of Fairmount Chemical Corporation Diazo Resin No. 4 (the reaction product of a diazodiphenylamine-formaldehyde condensate and zinc chloride)

Plate 2:
An aqueous solution of Andrews Paper and Chemical, Co. Diazo Resin — P1004 (a bisulphate salt of a diazodiphenylamine-formaldehyde condensate)

Plate 3:
A 2-methoxyethanol/dimethyl formamide solution of the reaction product of a diazodiphenylamine-formaldehyde condensate and p-toluene sulphonic acid.

Plate 4:
A 2-methoxy ethanol solution of the reaction product of a diazo diphenylamine-formaldehyde condensate and 2-hydroxy-4-methoxybenzophenone-5-sulphonic acid.

Plate 5:
A toluene/isopropanol solution of the reaction product of a diazodiphenylamine-formaldehyde condensate and sodium lauryl sulphonate.

Plate 6:
A toluene/isopropanol solution of the reaction product of a diazodiphenylamineformaldehyde condensate and tri-isopropyl naphthalene sulphonic acid.

Plate 7:
As plate 5 but including MACRYNAL SN510 in an amount equal to twice the weight of the diazo condensate. (MACRYNAL SN510 is an acrylic resin with hydroxyl functionality manufactured by Resinous Chemicals)

Plate 8:
A 2-methoxy ethanol/butyl acetate solution of the reaction product of a 3-methoxy diphenylamine-4-diazonium sulphate/4,4'-bismethoxy-methyl-diphenyl ether condensate and sodium mesitylene sulphonate.

Each radiation sensitive plate was exposed beneath a negative transparency in a printing down frame and developed with an aqueous solution of isopropanol. Separate areas of each plate were then treated respectively with a finishing composition in the form of a 2% aqueous solution of acetoacetanilide; 3-hydroxyacetoacetanilide; 4-chloro-2,5-dimethoxyaceto acetanilide; 4-morpholinoacetoacetanilide; N-acetoacetylbenzylamine; N,N'-bisacetoacetyl ethylene diamine; and N-(cyanoacetyl) morpholine; the solution in each case being alkaline and including a surfactant (Dowfax 2A1). One area of each plate was left untreated. The plates were dried and the whole of the plate surfaces were treated with a de-sensitiser (aqueous gum arabic solution). The plates were stored in daylight for one day and then placed on an offset press. Whereas the areas on the plates which had been treated prior to being desensitised with gum arabic accepted ink within 3 or 4 revolutions of the press, the area of each plate which had been desensitised only was reluctant to take ink even after 30 revolutions.

The tests were repeated but in this case the plates were stored for one week in daylight before being placed on the press. The treated areas of each plate again took ink quickly, whereas the areas which has been de-sensitised only would not take ink even after several hundred revolutions.

### Example 2
The procedure of Example 1 was repeated except that the following finishing composition was used in each case:—

| | |
|---|---|
| Gum arabic | 8.7% |
| Acetoacetanilide | 2.1% |
| Dowfax 2A1 | 8.7% |
| Water | 80.5% |
| Sodium hydroxide | to pH 9.8 |

Dowfax 2A1 is the sodium salt of dodecylated oxydibenzene disulphonic acid and is a surfactant available from the Dow Chemical Company.

When placed on the press all the plates took ink satisfactorily in those areas which had been treated with the finishing solution.

### Example 3
Example 2 was repeated except that the following finishing composition was used in each case:—

| | |
|---|---|
| Dextrin | 8.5% |
| Acetoacetanilide | 1.8% |
| Dowfax 2A1 | 4.4% |
| Water | 83.8% |
| Trisodium phosphate | to pH 10.5 |

Results similar to those of Example 2 were obtained.

### Example 4
Two proprietory negative working plates, namely an N6 plate manufactured by Hoechst AG and a Target plate manufactured by Frys Metals (Graphics) were image-wise exposed and developed according to the manufacturers instructions. One half of each plate was treated with the finishing composition of Example 2 and the other half was treated with gum arabic. When placed on a press after storage as in Example 1, the half of each plate treated with the finishing composition took ink readily whereas the other half blinded and would not take ink.

### Example 5
A sheet of grained, anodised and silicated aluminium was coated with a radiation sensitive composition comprising a 2-methoxy ethanol/ dimethyl formamide solution of the reaction product of a diazodiphenylamineformaldehyde condensate and fluoroboric acid and dried. The resultant radiation sensitive plate was then treated in the same manner as the radiation sensitive plates of Example 1 and similar results were obtained.

### Example 6
The procedure of Example 1 was repeated except that the following finishing composition was used in each case:—

| | |
|---|---|
| Ammonium alginate | 8.0% |
| Acetoacetanilide | 2.0% |
| Dowfax 2A1 | 4.0% |
| Water | 84.0% |
| Trisodium phosphate | to pH 10.5 |

Similar results were obtained.

**Claims for the Contracting States: BE CH DE FR GB IT LI LU NL SE**

1. A method of producing a lithographic printing plate from a radiation sensitive plate comprising a substrate having thereon a radiation sensitive coating containing a diazo compound, which method comprises image-wise exposing the radiation sensitive plate, developing the image-wise exposed plate to selectively remove the non-radiation struck areas of the coating from the substrate, and applying a lithographic desensitising material to the developed plate characterised in that the developed plate is treated with a finishing composition either prior to, or simultaneously with, the application of the lithographic desensitising material, said finishing composition comprising an active methylene group-containing compound capable of eliminating diazo groups by entering into an azo coupling reaction.

2. A method according to claim 1 wherein said compound is acetoacetanilide; 3-hydroxyacetoacetanilide; 4-chloro-2, 5-dimethoxyacetoacetanilide; or 4-morphilinoacetoacetanilide.

3. A method according to claim 1 or 2 wherein the lithographic desensitising material is dextrin; gum arabic; an alginate; and cellulose derivative; acrylamide homopolymer, or a polymer containing structural units derived from acrylamide and from 1 to 25% by weight of structural units containing carboxyl groups.

4. A method according to any one of the preceding claims wherein the diazo compound is a condensation product of a diazodiphenylamine and formaldehyde.

5. A plate finishing composition for treating an exposed and developed radiation sensitive plate in lithographic printing plate production, which composition comprises (i) an active methylene group-containing compound capable of eliminating diazo groups by entering into an azo coupling reaction, (ii) a lithographic desensitising material, and (iii) water.

6. A composition as claimed in claim 5 wherein said desensitising material is present in an amount of from 0.5 to 50% by weight and said compound is present in an amount of from 0.25% by weight to the amount required to form a saturated solution.

7. A composition as claimed in claim 5 or 6 wherein said compound is acetoacetanilide; 3-hydroxyacetoacetanilide; 4-chloro-2,5-dimethoxyacetoacetanilide; or 4-morpholinoacetoacetanilide; the composition being alkaline.

8. A composition as claimed in claim 5 or 6 wherein said compound is N-acetoacetylbenzylamine; N, N'-bisacetoacetylethylene diamine; N-(cyanoacetyl)morpholine; or 1-phenyl-3-methyl-5-pyrazolone, the composition being alkaline.

9. A composition as claimed in claim 8 wherein the lithographic desensitising material is dextrin; gum arabic; an alginate; a cellulose derivative; acylamide homopolymer; or a polymer containing structural units derived from acrylamide and from 1 to 25% by weight of structural units containing carboxyl groups.

10. A composition as claimed in any one of claims 5 to 9 which additionally includes a surfactant and/or a dispersing agent.

11. The use of a composition comprising an active methylene group-containing compound capable of eliminating diazo groups by entering into an azo-coupling reaction for the purpose of improving the ink receptivity of a lithographic printing plate obtained by the image-wise exposure of a radiation sensitive coating containing a diazo compound, the development of the exposed plate to selectively remove the non-radiation struck areas of the coating, and the application of a lithographic desensitising material.

**Claims for the Contracting State: AT**

1. A method of producing a lithographic printing plate from a radiation sensitive plate comprising a substrate having thereon a radiation sensitive coating containing a diazo compound, which method comprises image-wise exposing the radiation sensitive plate, developing the image-wise exposed plate to selectively remove the non-radiation struck areas of the coating from the substrate, and applying a lithographic desensitising material to the developed plate characterised in that the developed plate is treated with a finishing composition either prior to, or simultaneously with, the application of the lithographic desensitising material, said finishing composition comprising an active methylene group-containing compound capable of eliminating diazo groups by entering into an azo coupling reaction.

2. A method according to claim 1 wherein said compound is acetoacetanilide; 3-hydroxyacetoacetanilide; 4-chloro-2, 5-dimethoxyacetoacetanilide; or 4-morpholinoacetoacetanilide.

3. A method according to claim 1 or 2 wherein the lithographic desensitising material is dextrin; gum arabic; an alginate; and cellulose derivative; acrylamide homopolymer, or a polymer containing structural units derived from acrylamide and from 1 to 25% by weight of structural units containing carboxyl groups.

4. A method according to any one of the preceding claims wherein the diazo compound is a condensation product of a diazodiphenylamine and formaldehyde.

5. A method of forming a composition for treating an exposed and developed radiation sensitive plate in lithographic printing plate production characterised in that it comprises admixing together (i) an active methylene group-containing compound capable of eliminating diazo groups by entering into an azo coupling reaction, (ii) a lithographic desensitising material, and (iii) water to obtain the desired composition.

6. A method in accordance with claim 5 wherein said desensitising material is present in an amount of from 0.5 to 50% by weight and said compound is present in an amount of from 0.25% by weight to the amount required to form a saturated solution.

7. A method in accordance with claim 5 or 6 wherein said compound is acetoacetanilide; 3-hydroxyacetoacetanilide; 4-chloro-2, 5-dimethoxyacetoacetanilide; or 4-morpholinoacetoacetanilide; the composition is alkaline.

8. A method in accordance with claim 5 or 6 wherein said compound is N-acetoacetylbenzylamine; N, N'-bisacetoacetylethylene diamine; N-(cyanoacetyl)morpholine; or 1-phenyl-3-methyl-5-pyrazolone; and the composition is alkaline.

9. A method in accordance with claim 8 wherein the lithographic desensitising material is dextrin; gum arabic; an alginate; a cellulose derivative; acylamide homopolymer; or a polymer containing structural units derived from acrylamide and from 1 to 25% by weight of structural units containing carboxyl groups.

10. A method in accordance with claim 5 of forming such a composition which additionally includes a PH-adjusting component and a surfactant which method comprises the sequential steps of heating the water; adding the pH-adjusting component to the water; adding the surfactant to the water; adding the diazo eliminating compound to the water; and adding the lithographic desensitising material to the water to obtain the desired composition.

11. The use of a composition comprising an active methylene group-containing compound capable of eliminating diazo groups by entering into an azo-coupling reaction for the purpose of improving the ink receptivity of a lithographic printing plate obtained by the image-wise exposure of a radiation sensitive coating containing a diazo compound, the development of the exposed plate to selectively remove the non-radiation struck areas of the coating, and the application of a lithographic desensitising material.

**Patentansprüche für die Vertragsstaaten: DE CH DE FR GB IT LI LU NL SE**

1. Verfahren zum Herstellen einer Steindruckplatte aus einer strahlungsempfindlichen Platte mit einem Substrat, auf der ein strahlungsempfindlicher Überzug vorgesehen ist, der eine Diazoverbindung enthält, wobei die strahlungsempfindliche Platte bildmäßig bestrahlt wird, die bildmäßig bestrahlte Platte entwickelt wird, um die unbestrahlten Bereiche des Überzuges von dem Substrat zu trennen, und ein lithographischer Desensibilisator auf die entwickelte Platte aufgebracht wird, dadurch gekennzeichnet, daß die entwickelte Platte mit einem Nachbehandlungsmittel entweder vor oder zugleich mit der Aufbringung des lithographischen Desensibilisators behandelt wird, das eine eine aktive Methylengruppe enthaltende Verbindung enthält, die imstande ist, durch Eintritt in eine Azokupplungsreaktion Diazogruppen zu beseitigen.

2. Verfahren nach Anspruch 1, dadurch gekennzeichnet, daß die genannte Verbindung Acetoacetanilid, 3-Hydroxyacetoacetanilid, 4-Chlor-2,5-dimethoxyacetoacetanilid oder 4-Morpholinoacetoacetanilid ist.

3. Verfahren nach Anspruch 1 oder 2, dadurch gekennzeichnet, daß der lithographische Desensibilisator Dextrin, Gummiarabikum, ein Alginat, ein Zellulosederivat, Acrylamidhomopolymerisat, oder ein Polymer ist, das von Acrylamid abgeleitete Struktureinheiten und 1 bis 25 Gew.-% carboxylgruppenhaltige Struktureinheiten enthält.

4. Verfahren nach einem der vorhergehenden Ansprüche, dadurch gekennzeichnet, daß die Diazoverbindung ein Kondensationsprodukt eines Diazodiphenylamins und des Formaldehyds ist.

5. Stoffzusammensetzung zum Nachbehandeln einer bestrahlten und entwickelten, strahlungsempfindlichen Platte bei der Herstellung einer Steindruckplatte, dadurch gekennzeichnet, daß die Stoffzusammensetzung (i) eine eine aktive Methylengruppe enthaltende Verbindung, die geeignet ist, durch Eintritt in eine Azokupplungsreaktion Diazogruppen zu beseitigen (ii) einen lithographischen Desensibilisator und (iii) Wasser.

6. Stoffzusammensetzung nach Anspruch 5, dadurch gekennzeichnet, daß der Desensibilisator in einer Menge von 0,5 bis 50 Gew.% und die genannte Verbindung in einer Menge von 0,25 Gew.% bis zu der zur Bildung einer gesättigten Lösung erforderlichen Menge vorhanden sind.

7. Stoffzusammensetzung nach Anspruch 5 oder 6, dadurch gekennzeichnet, daß die genannte Verbindung Acetoacetanilid, 3-Hydroxyacetoacetanilid, 4-Chlor-2,5-dimethoxyacetoacetanilid oder 4-Morpholinoacetoacetanilid und die Stoffzusammensetzung alkalisch ist.

8. Stoffzusammensetzung nach Anspruch 5 oder 6, dadurch gekennzeichnet, daß die genannte Verbindung N-acetoacetylbenzylamin, N,N'-Bisacetoacetyläthylendiamin, N-(Cyanacetyl)morpholin oder 1-Phenyl-3-methyl-5-pyrazolon und die Stoffzusammensetzung alkalisch ist.

9. Stoffzusammensetzung nach Anspruch 8, dadurch gekennzeichnet, daß der lithographische Desensibilisator Dextrin, Gummiarabikum, ein Alginat, ein Zellulosederivat, Acrylamidhomopolymerisat, oder ein Polymer ist, das von Acrylamid abgeleitete Struktureinheiten und 1 bis 25 Gew.% carboxylgruppenhaltige Struktureinheiten enthält.

10. Stoffzusammensetzung nach einem der Ansprüche 1 bis 5, dadurch gekennzeichnet, daß sie zusätzlich ein oberflächenaktives Mittel und/oder ein Dispergiermittel enthält.

11. Verwendung einer Stoffzusammensetzung, die eine, eine aktive Methylengruppe enthaltende Verbindung enthält, die geeignet ist, durch Eintritt in eine Azokupplungsreaktion Diazogruppen zu beseitigen, zur Verbesserung der Farbannahmefähigkeit einer Steindruckplatte, die erhalten worden ist, indem ein eine Diazooverbindung enthaltender, strahlungsempfindlicher Überzug bildmäßig bestrahlt und die bestrahlte Platte entwickelt wird, um die umbestrahlten Bereiche des Überzugs selektiv zu entfernen, und ein lithographischer Desensibilisator aufgebracht wird.

**Patentansprüche für die Vertragsstaat: AT**

1. Verfahren zum Herstellen einer Steindruckplatte aus einer strahlungsempfindlichen Platte mit einem Substrat, auf der ein strahlungsempfindlicher Überzug vorgesehen ist, der eine Diazoverbindung enthält, wobei die strahlungsempfindliche Platte bildmäßig bestrahlt wird, die bildmäßig bestrahlte Platte entwickelt wird, um die unbestrahlten Bereiche des Überzuges von dem Substrat zu trennen, und ein lithographischer Desensibilisator auf die entwickelte Platte aufgebracht wird, dadurch gekennzeichnet, daß die entwickelte Platte mit einem Nachbehandlungsmittel entweder vor oder zugleich mit der Aufbringung des lithographischen Desensibilisators behandelt wird, das eine eine aktive Methylengruppe enthaltende Verbindung enthält, die imstande ist, durch Eintritt in eine Azokupplungsreaktion Diazogruppen zu beseitigen.

2. Verfahren nach Anspruch 1, dadurch gekennzeichnet, daß die genannte Verbindung Acetoacetanilid, 3-Hydroxyacetoacetanilid, 4-Chlor-2,5-dimethoxyacetoacetanilid oder 4-Morpholinoacetoacetanilid ist.

3. Verfahren nach Anspruch 1 oder 2, dadurch gekennzeichnet, daß der lithographische Desensibilisator Dextrin, Gummiarabikum, ein Alginat, ein Zellulosederivat, Acrylamidhomopolymerisat, oder ein Polymer ist, das von Acrylamid abgeleitete Struktureinheiten und 1 bis 25 Gew.-% carboxylgruppenhaltige Struktureinheiten enthält.

4. Verfahren nach einem der vorhergehenden Ansprüche, dadurch gekennzeichnet, daß die Diazoverbindung ein Kondensationsprodukt eines Diazodiphenylamins und des Formaldehyds ist.

5. Verfahren zum Erzeugen einer Stoffzusammensetzung zum Behandeln einer bestrahlen und entwickelten, strahlungsempfinglichen Platte bei der Herstellung einer Steindruckplatte, dadurch gekennzeichnet, daß (i) eine eine aktive Methylengruppe enthaltende Verbindung, die geeignet ist, durch Eintritt in eine Azokupplungsreaktion Diazogruppen zu beseitigen (ii) ein lithographischer Desensibilisator und (iii) Wasser miteinander vermischt werden, um die gewünschte Stoffzusammensetzung zu erhalten.

6. Verfahren nach Anspruch 5, dadurch gekennzeichnet, daß der Desensibilisator in einer Menge von 0,5 bis 50 Gew.% und die genannte Verbindung in einer Menge von 0,25 Gew.% bis zu der zur Bildung einer gesättigten Lösung erforderlichen Menge vorhanden sind.

7. Verfahren nach Anspruch 5 oder 6, dadurch gekennzeichnet, daß die genannte Verbindung Acetoacetanilid, 3-Hydroxyacetoacetanilid, 4-Chlor-2,5-dimethoxyacetoacetanilid oder 4-Morpholinoacetoacetanilid und die Stoffzusammensetzung alkalisch ist.

8. Verfahren nach Anspruch 5 oder 6, dadurch gekennzeichnet, daß die genannte Verbindung N-Acetoacetylbenzylamin, N,N'-Bisacetoacetyläthylendiamin, N-(Cyanacetyl)morpholin oder 1-Phenyl-3-methyl-5-pyrazolon und die Stoffzusammensetzung alkalisch ist.

9. Verfahren nach Anspruch 8, dadurch gekennzeichnet, daß der lithographische Desensibilisator Dextrin, Gummiarabikum, ein Alginat, ein Zellulosederivat, Acrylamidhomopolymerisat, oder ein Polymer ist, das von Acrylamid abgeleitete Struktureinheiten und 1 bis 25 Gew.% carboxylgruppenhaltige Struktureinheiten enthält.

10. Verfahren nach Anspruch 5 zum Herstellen einer derartigen Stoffzusammensetzung, die zusätzlich einen Bestandteil zum Einstellen des pH-Wertes und ein Tensid enthält, dadurch gekennzeichnet, daß nacheinander folgende Schritte durchgeführt werden: Erhitzen des Wassers, Zusetzen des Besteandteils zum Einstellen des pH-Wertes zu dem Wasser, Zusetzen des Tensids zu dem Wasser, Zusetzen der die Diazogruppen beseitigenden Verbindung zu dem Wasser und Zusetzen des lithographischen Desensibilisators zu dem Wasser, so daß die gewünschte Stoffzusammensetzung erhalten wird.

11. Die Verwendung einer Stoffzusammensetzung, die eine, eine aktive Methylengruppe enthaltende Verbindung enthält, die geeignet ist, durch Eintritt in eine Azokupplungsreaktion Diazogruppen zu beseitigen, zur Verbesserung der Farbannahmefähigkeit einer Steindruckplatte, die erhalten worden ist, indem ein eine Diazoverbindung enthaltender, strahlungsempfindlicher Überzug bildmäßig bestrahlt und die bestrahlte Platte entwickelt wird, um die unbestrahlten Bereiche des Überzuges selektiv zu entfernen, und ein lithographischer Desensibilisator aufgebracht wird.

**Revendications pour les Etats contractouts: BE CH DE FR GB IT LI LU NL SE**

1. Procédé d'obtention d'une plaque ou planche d'impression lithographique à partir d'une plaque sensible aux radiations ou photosensible comprenant un support revêtu d'une couche photosensible contenant un composé diazo, lequel procédé comprend l'exposition pour y impressionner de l'image de la plaque photosensible et le développement de la plaque impressionnée par l'image pour éliminer sélectivement du support les zones de la couche non impressionnées par les radiations, et l'application d'un désensibilisateur lithographique zur la plaque développée caractérisé en ce que la plaque développée est traitée par une composition de finition, soit préalablement, soit simultanément à l'application du désensibilisateur lithographique, ladite composition de finition comprenant un composé contenant des groupes méthylène actifs susceptibles d'éliminer les groupes diazo en entrant en réaction de couplage azo.

2. Procédé selon la revendication 1, dans lequel ledit composé est l'acétoacétanilide; le 3-hydroxy-acétoacétanilide; le 4-chloro-2,5-diméthoxyacétoacétanilide, ou le 4-morpholino-acétoacétanilide.

3. Procédé selon la revendication 1 ou 2, dans lequel le désensibilisateur lithographique est la dextrine, la gomme arabique, un alginate, un dérivé de la cellulose, l'amide acrylique homopolymère ou un polymère contenant des motifs dérivés de l'amide acrylique et de 1 à 25% en poids de motifs contenant des groupes carboxyles.

4. Procédé selon l'une quelconque des revendications précédentes, dans lequel le composé diazo est un produit de condensation d'une diazophénylamine et de formaldéhyde.

5. Composition de finition de plaque pour traiter une plaque ou planche photosensible exposée et développée pour l'obtention de plaques ou planches d'impression lithographique, laquelle composition comprend:
    (1) un composé contenant des groupes méthylène actifs susceptibles d'éliminer des groupes diazo en entrant en réaction de couplage azo;
    (2) un désensibilisateur lithographique; et,
    (3) de l'eau.

6. Composition telle que revendiquée à la revendication 5 dans laquelle ledit désensibilisateur est présent en quantité de 0,5 à 50% en poids et ledit composé est présent un quantité de 0,25% en poids jusqu'à la quantité requise pour obtenir une solution saturée.

7. Composition telle que revendiquée à la revendication 5 ou 6, dans laquelle ledit composé est l'acétoacétanilide; le 3-hydroxy-acétoacétanilide; le 4-chloro-2,5-diméthoxy-acétoacétanilide; ou le 4-morpholino-acétoacétanilide; la composition étant alcaline.

8. Composition telle que revendiquée à la revendication 5 ou 6, dans laquelle ledit composé est la N-acétoacétylbenzylamine; la N-N'bisacétoacétyléthylène diamine; la N-(cyanoacétyl)-morpholine; ou la 1-phényl-3-méthyl-5-pyrazolone; la composition étant alcaline.

9. Composition telle que revendiquée à la revendication 8, dans laquelle le désensibilisateur lithographique est la dextrine, la gomme arabique, un alginate, un dérivé de la cellulose, l'amide acrylique homopolymère ou un polymère contenant des motifs dérivés de l'amide acrylique et de 1 à 25% en poids de motifs contenant des groupes carboxyles.

10. Composition telle que revendiquée dans l'une quelconque des revendications 5 à 9, qui inclut additionnellement un agent tensio-actif et/ ou dispersant.

11. Application d'une composition comprenant un composé contenant des groupes méthylène actifs susceptibles d'éliminer les groupes diazo en entrant en réaction de couplage azo, afin d'améliorer la réceptivité à l'encrage des plaques ou planches d'impression lithographiques obtenues par exposition pour impression de l'image, d'une couche photosensible contenant un composé diazo et par développement de la plaque impressionée pour éliminer sélectivement les zones de la couche non impressionnées par les radiations.

**Revendications pour l'Etat contractant: AT**

1. Procédé d'obtention d'une plaque ou planche d'impression lithographique à partir d'une plaque sensible aux radiations ou photosensible comprenant un support revêtu d'une couche photosensible contenant un composé diazo, lequel procédé comprend l'exposition pour y impressionner de l'image de la plaque photosensible et le développement de la plaque impressionée par l'image pour éliminer sélectivement du support les zones de la couche non impressionées par les radiations, et l'application d'un désensibilisateur lithographique sur la plaque développée caractérisé en ce que la plaque développée est traitée par une composition de finition, soit préalablement, soit simultanément à l'application du désensibilisateur lithographique, ladite composition de finition comprenant un composé contenant des groupes méthylène actifs susceptibles d'éliminer les groupes diazo en entrant en réaction de couplage azo.

2. Procédé selon la revendication 1, dans lequel ledit composé est l'acétoacétanilide; le 3-hydroxy-acétoacétanilide; le 4-chloro-2,5-diméthoxyacétoacétanilide, ou le 4-morpholino-acétoacétanilide.

3. Procédé selon la revendication 1 ou 2, dans lequel le désensibilisateur lithographique est la dextrine, la gomme arabique, un alginate, un dérivé de la cellulose, l'amide acrylique homopolymère ou un polymère contenant des motifs dérivés de l'amide acrylique et de 1 à 25% en poids de motifs contenant des groupes carboxyles.

4. Procédé selon l'une quelconque des revendications précédentes, dans lequel le composé diazo est un produit de condensation d'une diazophénylamine et de formaldéhyde.

5. Procédé de fabrication d'une composition pour traiter une plaque ou planche photosensible exposée et développée pour l'obtention de plaques ou planches d'impression lithographique, caractérisé en ce qu'il comprend le mélange pour former ladite composition de:
(1) un composé contenant des groupes méthylène actifs susceptibles d'éliminer des groupes diazo en entrant en réaction de couplage azo;
(2) un désensibilisateur lithographique; et,
(3) de l'eau.

6. Procédé selon la revendication 5 dans lequel ledit désensibilisateur est présent en quantité de 0,5 à 50% en poids et ledit composé est présent en quantité comprise entre 0,25% en poids et la quantité requise pour obtenir une solution saturée.

7. Procédé selon la revendication 5 ou 6, dans laquelle ledit composé est l'acétoacétanilide; le 3-hydroxyacétoacétanilide; le 4-chloro-2,5-diméthoxyacétoacétanilide; ou le 4-morpholino-acétoacétanilide; la composition étant alcaline.

8. Procédé selon la revendication 5 ou 7, dans laquelle ledit composé est la N-acétoacétylbenzylamine; la N-N'bisacétoacétyléthylène diamine; la N-(cyanoacétyl)morpholine; ou la 1-phényl-3-méthyl-5-pyrazolone; la composition étant alcaline.

9. Procédé selon la revendication 7, dans laquel le désensibilisateur lithographique est la dextrine, la gomme arabique, un alginate, un dérivé de la cellulose, l'amide acrylique homopolymère ou un polymère contenant des motifs dérivés de l'amide acrylique et de 1 à 25% en poids de motifs contenant des groupes carboxyles.

10. Procédé selon la revendication 7 pour la fabrication d'une telle composition qui comprend de plus un composant de réglage du pH et un agent tensio-actif, ledit procédé comprenant les phases séquentielles de chauffage de l'eau, d'addition à l'eau du composant de réglage du pH, l'addition à l'eau de l'agent tensio-actif, l'addition à l'eau du composé d'élimination des diazo, et l'addition à l'eau du désensibilisant lithographique, de façon à obtenir la composition désirée.

11. Application d'une composition comprenant un composé contenant des groupes méthylène actifs susceptibles d'éliminer les groupes diazo en entrant en réaction de couplage azo, afin d'améliorer la réceptivité à l'encrage des plaques ou planches d'impression lithographiques obtenues par exposition pour impression de l'image, d'une couche photosensible contenant un composé diazo et par développement de la plaque impressionée pour éliminer sélectivement les zones de la couche non impressionnées par les radiations.